Europäisches Patentamt

(19) European Patent Office

Office européen des brevets

(11) Numéro de publication: **0 060 217**

**A1**

(12) # DEMANDE DE BREVET EUROPEEN

(21) Numéro de dépôt: **82810078.4**

(22) Date de dépôt: **18.02.82**

(51) Int. Cl.³: **G 01 L 9/00**
**G 01 L 9/08, H 01 L 41/08**

(30) Priorité: **10.03.81 FR 8104922**

(43) Date de publication de la demande:
**15.09.82 Bulletin 82/37**

(84) Etats contractants désignés:
**CH DE GB LI**

(71) Demandeur: **ASULAB S.A.**
**Faubourg du Lac 6**
**CH-2502 Bienne(CH)**

(72) Inventeur: **Michel, Jean**
**Rue de l'Observatoire 44**
**CH-2000 Neuchatel(CH)**

(72) Inventeur: **Debely, Pierre**
**Rue Ferdinand-Hodler 21**
**CH-1207 Geneve(CH)**

(74) Mandataire: **Dronne, Guy et al,**
**ASUAG Département Brevets et Licences Faubourg du Lac 6**
**CH-2501 Bienne(CH)**

(54) Elément vibrant pour détecteur de pression et détecteur de pression comportant un tel élément.

(57) L'invention a pour objet un elément vibrant pour détecteur de pression fonctionnant par résonance.

L'élément vibrant est taillé dans un cristal piézo-électrique de manière à former un disque (4) comportant trois barreaux épais (6, 8, 10) orientés radialement, à des intervalles angulaires égaux, et réunis pas des secteurs de membrane mince (12). Les barreaux portent des électrodes d'excitation (18, 18') formées par des dépôts conducteurs sur les faces latérales perpendiculaires au plan du disque. Ce dernier est sensiblement perpendiculaire à l'axe Z du quartz.

Application à la réalisation de capteur de pression de gaz.

Fig. 1

Croydon Printing Company Ltd

ESA 51

## ELEMENT VIBRANT POUR DETECTEUR DE PRESSION ET
## DETECTEUR DE PRESSION COMPORTANT UN TEL ELEMENT

La présente invention concerne un élément vibrant pour détecteur de pression et un détecteur comportant un tel élément.

Pour la mesure de la pression atmosphérique et des changements de pression, par un dispositif sous forme portative, tel qu'un altimètre, on peut utiliser plusieurs effets. En général, une capsule dans laquelle règne le vide et ayant des faces parallèles constituées par des membranes très élastiques, sert de détecteur, ou senseur. Dans un altimètre de type usuel, la déformation du fond de la capsule suivant la pression extérieure est amplifiée et transformée mécaniquement en un mouvement rotatif d'une aiguille, par un train de roues dentées.

D'autre part, on trouve actuellement sur le marché des détecteurs piézorésistifs, constitués d'une membrane en cristal de silicium dans laquelle sont formées des résistances par diffusion. Lorsque une différence de pression est exercée entre les deux faces de la membrane, la déformation qui en résulte provoque une variation de la résistance. Habituellement on réalise en plus des résistances de mesure, par diffusion simultanée, des résistances situées dans les zones qui ne sont pas soumises aux contraintes, de façon à obtenir un circuit de mesure en pont compensé en température, toutes les résistances ayant le même coefficient de température.

Tous ces détecteurs sont relativement coûteux, car ils nécessitent un ajustage individuel très soigné. En outre, la grandeur physique mesurée est transformée en une autre grandeur, analogique : angle ou variation de résistance. Récemment, on a proposé dans la littérature ( IEEE Transactions on industrial Electronics and Control Instrumentation, Vol. IECI- 25, n°1, Fév. 1978, pages 29-38), de réaliser les capsules de détection de pression selon un montage en résonateur. La membrane sensible constitue un diaphragme vibrant et l'on exploite la fréquence de résonance de la capsule couplée à un oscillateur électronique, cette fréquence variant avec la pression extérieure appliquée à la capsule. En effet, les changements de fréquence peuvent être mesurés avec des circuits logiques simples, et avec une très grande précision. Toutefois, la construction d'une telle capsule résonante est très délicate et elle ne se prête pas à une production économique en très grandes séries.

La présente invention permet d'éviter ces inconvénients grâce à un détecteur de pression conçu pour fonctionner en mode vibrant et pour faciliter la détermination d'une variation de pression par détection des variations de sa fréquence de résonance sous l'effet des variations de la pression régnant dans l'atmosphère où il est placé, la pression étant égale sur les deux faces ou une des faces étant soumise à une pression sensiblement nulle, tout en étant d'un mode de réalisation simplifié par rapport aux techniques de l'art antérieur. Dans ce but, l'invention concerne un élément vibrant pour détecteur de pression, caractérisé en ce qu'il est constitué par un cristal piézo-électrique taillé pour former d'une part au moins un barreau piézo-électriqe muni d'électrodes et d'autre part une membrane mince entourant les deux faces allongées du barreau. Ainsi le transducteur constitué par le barreau piézo-électrique et la membrane soumise à la pression à mesurer ne forme qu'une seule et même pièce et sont réalisés simultanément.

La pression ou la différence de pression à laquelle la membrane est soumise est transmise au barreau piézo-électrique, le déplacement de la membrane et donc celui du barreau sont freinés par le gaz environnant et la fréquence change avec la pression ambiante. La membrane joue donc un rôle très important. Lorsque le barreau est monté dans un circuit d'entretien des oscillations, la fréquence d'oscillation du barreau excité pour vibrer en flexion est modifiée en fonction de la pression à laquelle la membrane est soumise, ainsi que cela a déjà été expliqué.

Selon un premier mode de mise en oeuvre, l'élément vibrant est taillé dans un cristal piézo-électrique pour former un disque comportant des barreaux épais orientés radialement et réunis par des secteurs de membrane mince, et portant des dépôts conducteurs formant des électrodes d'excitation sur chacun des barreaux pour que ces barreaux vibrent en flexion de manière que le centre du disque se déplace perpendiculairement à son plan lorsque la périphérie du disque est immobilisée.

Conformément à l'invention, un tel élément vibrant est principalement destiné à être utilisé pour constituer un détecteur de pression dans lequel il forme une capsule étanche, et il est monté en résonateur dans un nombre en oscillateur grâce aux liaisons conductrices avec les électrodes des barreaux, qui le relie au circuit électronique.

Dans un mode de réalisation préféré de l'élément vibrant objet de l'invention, il est prévu trois barreaux comme définis ci-dessus, répartis à intervalles angulaires égaux. Les électrodes sont situées sur ces barreaux sur des faces latérales perpendiculaires au plan du disque. Le disque est limité sur son pourtour par une couronne circulaire épaisse intégrant les extrémités extérieures des barreaux, et l'ensemble est symétrique par rapport au plan des secteurs de membrane mince.

Selon un deuxième mode de réalisation, l'élément vibrant comprend un seul barreau muni dans le sens de sa longueur de deux portions de membrane mince disposées de part et d'autre du barreau. Le barreau est de préférence de coupe Z et les électrodes sont disposées sur les flancs du barreau en dessus et en dessous des portions de membrane mince.

L'invention sera maintenant plus complètement décrite dans des modes de réalisation préférés, mais nullement limitatifs, en se référant aux dessins annexés, dans lesquels :

- la figure 1 représente un disque en cristal piézo-électrique constituant un élément vibrant selon un premier mode de réalisation de l'invention, dans une vue générale en perspective;

- la figure 2 est une coupe de cet élément suivant un plan perpendiculaire au disque;

- la figure 3 représente un autre disque, en variante de l'élément de la figure 1;

- la figure 4 montre une coupe du disque de la figure 3, également selon un plan perpendiculaire au plan du disque;

- la figure 5 représente, en coupe transversale, un détecteur de pression selon l'invention, illustrant le montage de l'élément de la figure 3 dans un tel détecteur;

- les figures 6a et 6b représentent en perspective et en coupe transversale un second mode de réalisation dans lequel l'élément vibrant comporte qu'un seul barreau piézo-électrique;

- la figure 7 illustre un procédé de réalisation d'une pluralité d'éléments vibrants;

- les figures 8a à 8d montrent un exemple de réalisation du circuit de traitement des signaux délivrés par le détecteur de la figure 5; et

- la figure 9 montre de façon simplifiée le montage de l'élément vibrant des figures 6 dans un détecteur de pression.

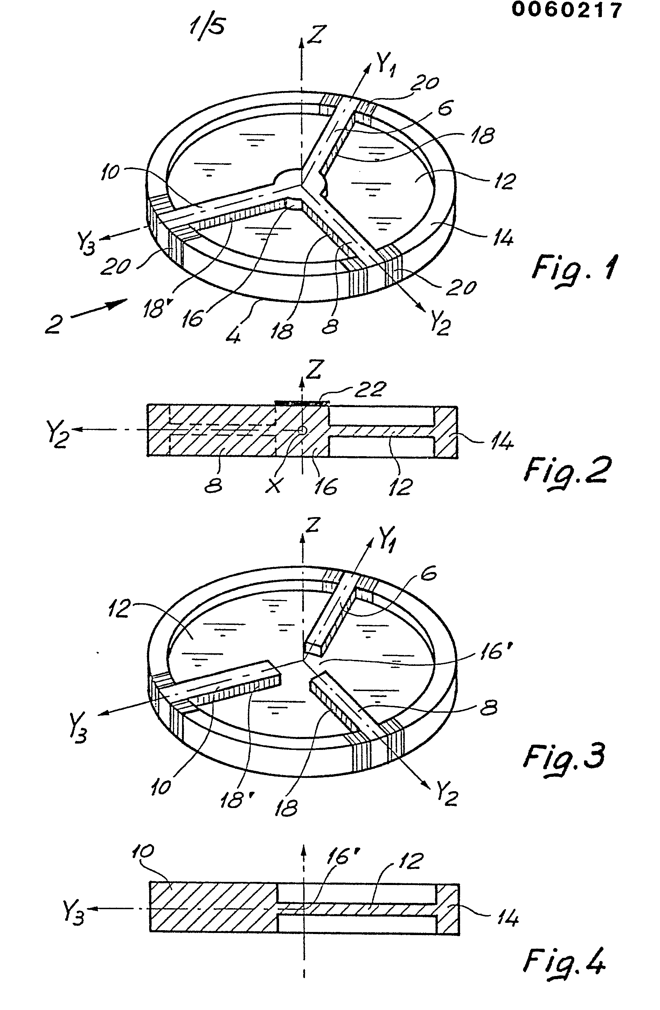

Conformément aux figures 1 et 2 et selon un premier mode de réalisation, un élément vibrant destiné à constituer l'élément sensible 2 d'un détecteur de pression par résonnance, est essentiellement constitué par un disque 4, taillé d'une seule pièce dans un cristal de quartz de manière à y former trois barreaux 6, 8 et 10 plus épais que les secteurs compris entre eux, où le cristal forme au contraire une membrane mince 12. Sur son pourtour, le disque 4 est épais, c'est-à-dire qu'il forme une couronne circulaire 14, de même épaisseur que les barreaux 6, 8 et 10 intégrant les extrémités extérieures de ces barreaux, ainsi que le pourtour des secteurs de la membrane mince 12. A leurs extrémités intérieures, les barreaux se rejoignent en une zone centrale 16, qui a la même épaisseur que les barreaux. La figure 2 montre que l'ensemble est symétrique par rapport au plan de la membrane mince 12 qui se situe en épaisseur au milieu des parties épaisses du disque 2.

S'agissant d'un cristal de quartz, le disque est taillé parallèlement à un plan sensiblement perpendiculaire à l'axe optique Z du cristal, et les trois barreaux 6, 8 et 10 sont disposés à intervalles angulaires égaux autour de cet axe, en respectant la symétrie ternaire électrique du quartz. Dans le cas des figures 1 à 4 les axes longitudinaux des barreaux sont orientés suivant les axes électriques Y1, Y2, Y3 du cristal. Ce choix permet d'avoir trois fois les mêmes propriétés mécaniques et piézo-électriques. Ainsi il est effectivement possible d'obtenir un déplacement global du disque selon la direction Z sous l'effet conjugué de la flexion des trois barreaux. La disposition adoptée facilite l'usinage du disque, comme cela sera expliqué ultérieurement, par attaque chimique du quartz suivant les procédés usuels, du fait qu'il est bien connu que l'attaque chimique du quartz se fait de façon préférentielle selon la direction Z.

Des électrodes d'excitation 18 et 18' sont formées sur chacun des barreaux 6, 8 et 10. Elles sont constituées par des dépôts conducteurs réalisés par métallisation. Elles sont disposées sur les deux ensembles de deux demi-flancs des barreaux. Elles sont isolées l'une de l'autre, et elles s'étendent sur toute la longueur des barreaux, des deux côtés de la membrane mince 12 depuis la zone centrale 16 jusqu'à la couronne circulaire 14 où elles sont prolongées par des dépôts conducteurs 20 formés localement autour de la couronne. Ces demi-flancs qui sont parallèles à l'axe Z résultent de la différence d'épaisseur entre les barreaux 6, 8 et 10 et la membrane 12. Ainsi chaque barreau comporte au-dessus de la membrane 12 (demi-flanc supérieurs) deux électrodes 18 et 18' se faisant face et sensiblement parallèles au plan $XY_j$ correspondant au barreau considéré; la même disposition d'électrodes se retrouve pour chaque barreau en dessous de la membrane mince 12, (demi-flancs inférieurs). Ces dernières électrodes ne sont pas représentées sur les figures. Ces dépôts 20 sont destinés à conduire le courant pour assurer l'application des tensions d'excitation aux électrodes 18 et 18' suivant la symétrie ternaire. Dans le cas des figures, les champs créés seront sensiblement parallèles à un axe X à travers chaque barreau. Or il est clair qu'une telle direction de champ est favorable pour obtenir un bon couplage piézo-électrique. Suivant les réalisations, les dépôts peuvent ou non permettre de porter les électrodes situées symétriquement au-dessus et en dessous de la membrane 12 à des tensions opposées. Avec ce dernier type d'excitation on obtient une vibration de chaque barreau en flexion, ce qui entraîne un déplacement du centre du disque selon l'axe Z du quartz.

En fonctionnement, les barreaux 6, 8 et 10 se comportent comme des barreaux individuels encastrés à leurs deux extrémités et le disque 4 est mis en vibration dans sa partie centrale du fait de la vibration des barreaux perpendiculairement à son plan, la couronne extérieure 14 servant à monter le disque dans un support mécanique.

Il faut donc remarquer que la mise en vibration d'un élément selon l'invention peut être obtenue par différents modes de fonctionnement, et que de même, et en liaison avec ces modes de fonctionnement, on peut, dans la taille du cristal de départ, orienter les barreaux suivant divers angles de coupe s'écartant de la coupe Z simple de la figure 1 dans le but, par exemple, de réduire l'influence des variations de la température ambiante dans un fonctionnement en flexion.

Sur les dessins, la figure 2, montre en 22, un dépôt isolé, réalisé par métallisation, sur la face supérieure de la zone centrale 16 du disque. Il constitue une surcharge qui peut être diminuée par faisceau laser ou augmentée par évaporation sous vide de métal pour régler à la valeur souhaitée la fréquence nominale de vibration du disque, par action sur la masse de la zone centrale.

Comme cela a déjà été mentionné, un avantage des éléments vibrants selon l'invention est qu'ils peuvent être aisément réalisés en grande série par attaques chimiques successives.

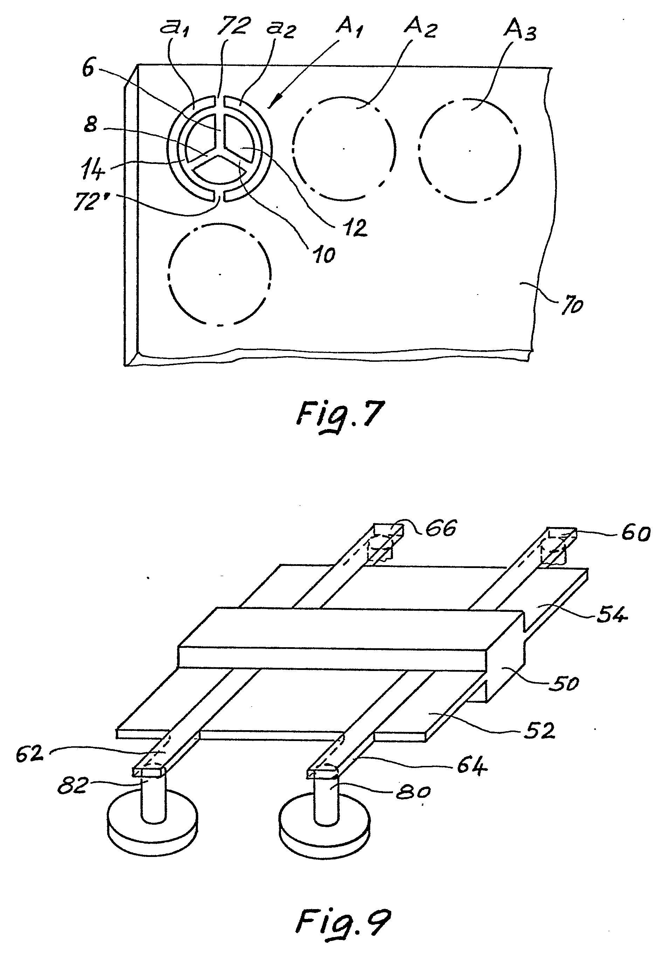

La figure 7 illustre la réalisation simultanée d'un grand nombre d'éléments vibrants $A_1$, $A_2$, $A_3$..... On part d'une plaquette de quartz 70 de coupe Z, c'est-à-dire que les faces de la plaquette sont parallèles au plan XY du quartz. On réalise un poli optique des deux faces puis on métallise chacune des deux faces avec une couche de chrome d'environ 200 $\overset{o}{A}$ et une couche d'or d'environ 2000 A. Par photolithographie, on supprime les métallisations dans les zones $a_1$ et $b_1$ pour chaque élément $A_i$. Puis on attaque le quartz non métallisé par une solution d'acide fluorhydrique. Cela donne les fentes $a_1$ et $a_2$. Ces fentes définissent le contour extérieur des disques 4 qui ne sont plus reliés au reste de la plaquette 70 que par des ponts minces 72 et 72'. Par une nouvelle opération de photolithographie on enlève la métallisation correspondant aux secteurs de membrane mince 12. Par une nouvelle attaque chimique partielle du quartz dans les zones dépourvues de métallisation, on définit les secteurs 12 et conséquemment les barreaux 8, 10, 12 ainsi que le rebord 14. Par une nouvelle opération de photolithographie, on ne laisse subsister des métallisations initiales que les zones correspondant aux connexions électriques 20. Ensuite, par évaporation sous vide de chrome puis d'or à travers un masque mécanique, on réalise les métallisations qui donnent pour chaque élément les électrodes des demi-flancs des barreaux. Il ne reste plus alors qu'à rompre les ponts 72 et 72' pour obtenir une pluralité d'éléments vibrants $A_i$.

La variante de réalisation des figures 3 et 4 diffère uniquement de la précédente par le fait que la zone centrale 16' est mince entre les extrémités intérieures des barreaux. De préférence la zone centrale 16' a la même épaisseur que le reste de la membrane 12. Cette réduction d'épaisseur au centre du disque permet, en diminuant l'effet d'encastrement des barreaux à cette extrémité, de faciliter la vibration par déplacement de la zone centrale lorsque les barreaux travaillent en flexion, mais peut-être au préjudice de la solidité mécanique de l'ensemble.

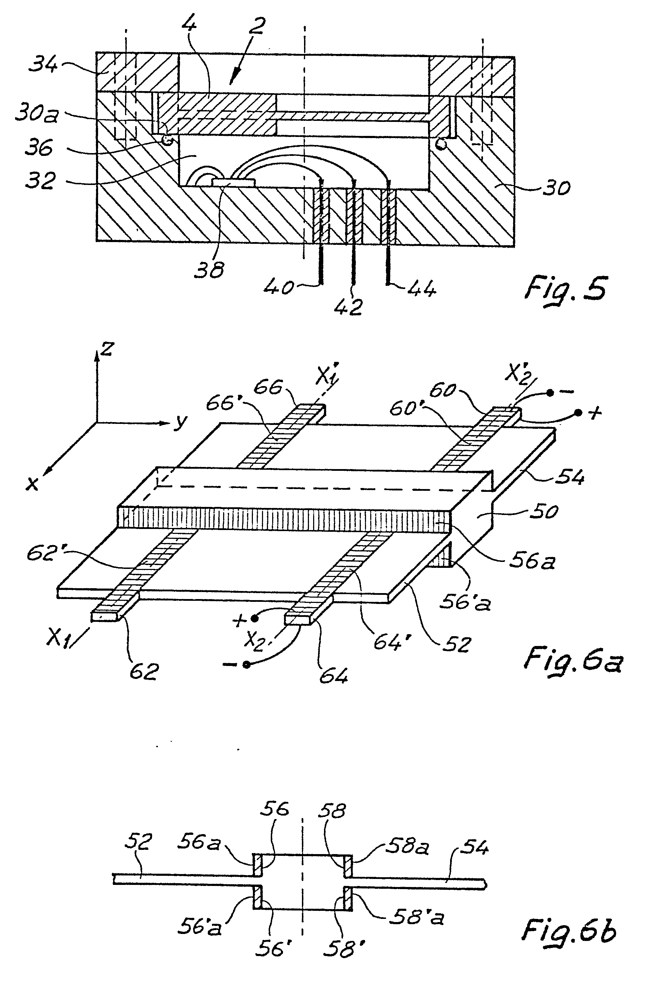

Un élément vibrant 2 selon cette variante est utilisé dans le détecteur de pression représenté sur la figure 5. Il est monté par sa couronne extérieure 14 en travers d'un boîtier creux 30 en matière isolante définissant une cavité 32. Une bague 34 vissée sur le dessus du boîtier 30 presse un joint annulaire 36 entre la couronne extérieure 14 du disque 4 et un épaulement 30a du boîtier. De la sorte, le disque 4 ferme la cavité 32 du boîtier 30. Le boîtier et le disque constituent une capsule étanche qui est mise sous vide. A l'intérieur de la cavité 32 est monté l'oscillateur 30, couplé avec l'élément vibrant 2. Ainsi la capacité des liaisons électriques entre l'oscillateur et l'élément oscillant est aussi faible que possible afin d'assurer une bonne stabilité et une bonne précision de l'ensemble de mesure. Le signal délivré par l'oscillateur peut être transporté de façon non critique jusqu'au circuit de mesure. Les liaisons électriques sont assurées par des pistes conductrices, non représentées sur la figure, qui relient l'oscillateur aux dépôts 20 existant sur la couronne extérieurs 14 du disque 1, et donc aux électrodes 18 et 18' formées sur les barreaux 6 à 10. Des fils conducteurs 40, 42, 44 traversant le fond du boîtier 30 par des passages étanches permettent de relier le système à une source d'énergie extérieure au boîtier, assurant l'alimentation électrique, et d'autre part à un appareil non représenté sur la figure 5, qui recueille l'information de fréquence délivré par l'ensemble oscillant. Cet appareil convertit les valeurs de fréquence en des valeurs de pression, correspondant à la différence entre la pression à l'intérieur du boîtier 30 et la pression à l'extérieur du boîtier, c'est-à-dire la pression appliquée au disque 4. Il est clair que dans l'élément vibrant la membrane mince joue le rôle de membrane vibrante et que les barreaux servent d'une part à exciter la membrane et d'autre part à délivrer un signal électrique dont la fréquence est modifiée par la pression appliquée à la membrane mince. Bien entendu le capteur de pression aurait pu utiliser un élément vibrant selon les figures 1 et 2.

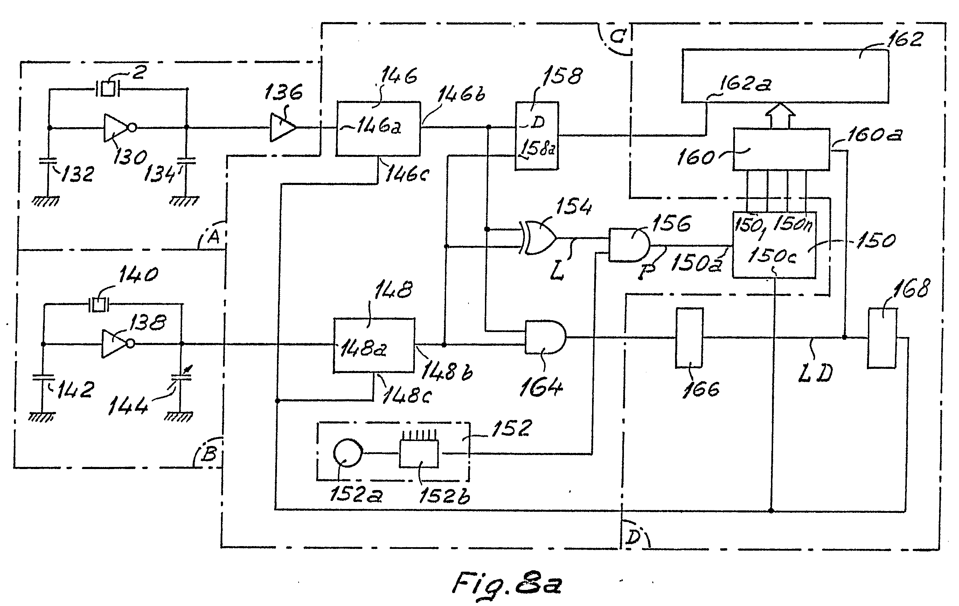

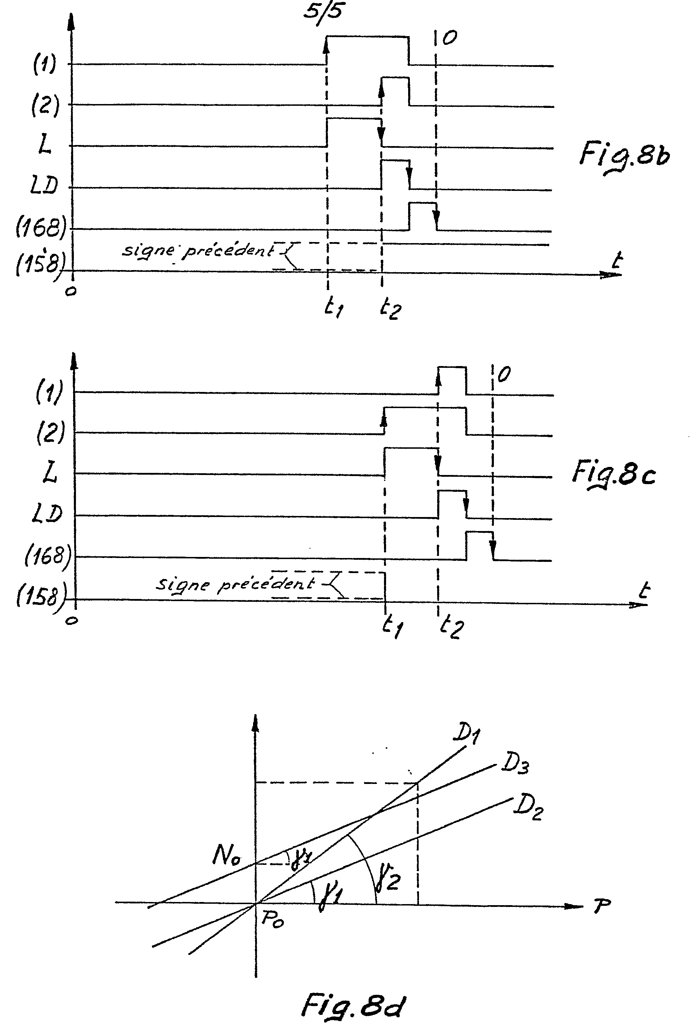

Les figures 8 illustrent un mode de réalisation du circuit de traitement du signal délivré par l'oscillateur de mesure.

Le circuit oscillant de mesure A comprend l'élément vibrant 2 de mesure décrit précédemment et le circuit d'entretien 30 de type connu. Ce circuit comprend l'amplificateur 130 avec, en contre-réaction, l'élément oscillant 2. Des capacités 132 et 134 sont montées respectivement entre l'entrée et la sortie de l'amplificateur d'une part et la masse d'autre part. Ce circuit est complété par un amplificateur d'isolation 136.

Un circuit oscillant de référence B a une structure sensiblement identique et comprend l'amplificateur 138 avec, en contre-réaction, l'élément oscillant de référence 140. Ce circuit comprend, en outre, les capacités 142 et 144. Il faut observer que la capacité 144 est réglable pour pouvoir adapter la fréquence de référence comme cela sera expliqué ultérieurement.

Des moyens de comparaisons C comprennent essentiellement deux compteurs par M (M: nombre entier) référencés respectivement 146 et 148, un troisième compteur 150 et un générateur 152 d'impulsions électriques à fréquence réglable. Plus précisément, les entrées d'horloge 146a et 148a des compteurs 146 et 148 reçoivent les impulsions délivrées par les circuits oscillants A et B. Les sorties 146b et 148b des compteurs 146 et 148 sont reliées aux deux entrées d'une porte OU EXCLUSIF 154. La source de fréquence variable 152 est constituée, de préférence, par un générateur 152a qui délivre un signal impulsionnel à fréquence élevée fixe et dont la sortie est reliée à un diviseur programmable 152b. A la sortie du diviseur 152b, le signal a donc la fréquence $f_c$ réglée par le taux de division du diviseur 152b. Bien entendu, le générateur 152 pourrait aussi être constitué par un générateur à fréquence commandable.

La sortie du générateur 152 et la sortie de la porte 154 sont reliées respectivement aux deux entrées d'une porte ET 156. L'entrée d'horloge 150a du troisième compteur 150 est reliée à la sortie de la porte ET 156. Les sorties des compteurs 146 et 148 sont reliées respectivement à l'entrée D et à l'entrée d'horloge 158a d'un bistable D 158 dont la fonction est de donner le signe de la pression mesurée par l'élément oscillant, c'est-à-dire l'ordre dans lequel se présente le front de montée des signaux délivrés respectivement par les compteurs 146 et 148.

Le circuit d'affichage et de remise à zéro D comprend une mémoire 160 dont les entrées sont reliées aux sorties binaires $150_1$ à $150_n$ du compteur 150. La mémoire 160 est connectée elle-même à un ensemble de décodage et d'affichage 162. L'ensemble 162 d'affichage comprend une entrée particulière 162a reliée à la sortie du bistable 158 pour afficher le signe de la pression par rapport à la pression de référence donnée par le circuit B.

Les sorties 146b et 148b des compteurs 146 et 148 sont également respectivement reliées aux deux entrées d'une porte ET 164. La sortie de la porte 164 est reliée à l'entrée du monostable 166 qui est du type "non rééxcitable". La sortie 166a du monostable 166 délivre un signal de commande LD qui est appliqué d'une part à l'entrée du deuxième monostable 168 et d'autre part à l'entrée de commande 160a de la mémoire 160. Le monostable 168 délivre une impulsion de remise à zéro qui est appliquée aux entrées de remise à zéro 146c, 148c et 150c respectivement des compteurs 146, 148 et 150.

Le fonctionnement du détecteur de pression qui vient d'être décrit est le suivant :

Le compteur 146 compte les impulsions délivrées par l'oscillateur de mesure A. Lorsque le compteur a compté M impulsions, sa sortie passe à l'état logique $\underline{1}$, comme le montre le diagramme (1) des figures 8b et 8c.

Simultanément, le compteur 148 compte les impulsions délivrées par l'oscillateur de référence B. Lorsque le compteur a compté M impulsions, sa sortie passe au niveau logique 1, comme le montre le diagramme (2) des figures 8b et 8c. Soit $T_t$ le temps que met le compteur 146 à compter M impulsions et $T_r$ le temps que met le compteur 148 à compter M impulsions. Le signal L qui apparaît à la sortie de la porte OU EXCLUSIF 154 a un niveau logique 1 entre

les instants $t_1$ et $t_2$ où les sorties des compteurs 146 et 148 passent à l'état logique 1. Le signal L a donc le niveau logique 1 pendant une durée $T_t - T_r$. Dans le cas de la figure 8b, le temps $T_t$ est inférieur au temps $T_r$, c'est-à-dire que la pression à mesurer est supérieure à la pression de référence. Au contraire, dans le cas de la figure 8c, le temps $T_t$ est supérieur au temps $T_r$, donc la pression à mesurer est inférieure à la pression de référence Po.

Le compteur 150 reçoit sur son entrée 150a les impulsions du signal P délivré par la porte ET 156. Il reçoit donc les impulsions délivrées par le générateur 152 entre les instants $t_1$ et $t_2$. En conséquence, à partir de l'instant $t_2$ (fig. 8b), le contenu du compteur 150 est égal au nombre d'impulsions N émises par le générateur 152 pendant le temps $T_t - T_r$. Ce nombre N est représentatif de la pression P à mesurer comme cela sera expliqué ultérieurement. De plus, à l'instant $t_2$ (fig. 8b), la porte ET 164 voit sa sortie passer au niveau logique 1, pendant le temps $\tau_1$ fixé par sa constante de temps, ce qui donne le signal LD. Le signal LD délivré par le monostable 166 commande le déblocage de la mémoire 160 et le nombre N d'impulsions est appliqué au système de décodage et d'affichage 162. Le front descendant du signal LD provoque le changement d'état de la sortie du monostable 168 qui passe au niveau logique 1 pendant le temps $\tau_2$ fixé par sa constante de temps. Cette impulsion remet à zéro les compteurs 146, 148 et 150. Lorsqu'il apparaît le front descendant de cette impulsion, le dispositif est prêt pour une nouvelle mesure de pression.

En résumé, le compteur 150 compte les impulsions du signal délivré par le générateur d'impulsions 152 dans la fenêtre limitée par les instants $t_1$ et $t_2$. Le nombre N d'impulsions représente la pression P à mesurer, la relation entre N et P étant connue pour un élément vibrant donné. C'est senbiblement une droite.

Le réglage du capteur de pression est réalisé en agissant sur la fréquence $f_C$ du signal délivré par le générateur 152 et sur la valeur de la capacité 144 de l'oscillateur de référence.

La figure 8d montre plusieurs droites pour différents réglages $D_1$, $D_2$ et $D_3$ qui donnent la relation sensiblement linéaire entre la pression P et le nombre N d'impulsions comptées par le compteur 150. La modification de la fréquence $f_C$ permet de modifier le rapport de proportionnalité entre la pression P et le nombre d'impulsions comptées. Elle agit donc sur la valeur de l'angle $\gamma$ ($\gamma_1$, $\gamma_2$.....) Au contraire, une action sur la capacité 144 modifie la valeur de référence, c'est-à-dire le nombre No d'impulsions correspondant à la pression de référence Po. Sur la figure 8d, la droite $D_1$ correspond à un réglage optimal puisque No = 0 pour P = Po et que l'angle $\gamma = \gamma_2$ correspond à une bonne sensibilité du capteur de pression.

Pour régler la valeur de la capacité 144, le capteur de pression (oscillateur A) est placé dans une ambiance à la pression Po. Le temps $T_t$ correspond donc à la pression $P_o$. La capacité 144 est modifiée jusqu'à ce que le compteur 150 ne compte aucune impulsion du générateur 152. Dans cette situation, $T_r = T_t$ et l'oscillateur B délivre donc un signal à une fréquence de référence correspondant à P = Po. Ce réglage est bien sûr indépendant du réglage de la fréquence $f_C$.

La valeur de l'angle $\gamma$ est réglée en agissant sur la fréquence $f_C$ sans modifier la capacité 144.

Les figures 6 représentent un autre mode de réalisation de l'élément vibrant. Ce mode de réalisation obéit bien sûr aux mêmes principes généraux puisqu'il utilise une membrane mince en quartz et un barreau épais taillés dans un même cristal de quartz. Selon ce mode de réalisation l'élément vibrant comporte un seul barreau associé à une membrane mince pour amplifier les effets de la pression.

L'élément sensible comprend un seul barreau piézo-électrique 50 et, de part et d'autre de ce barreau, des portions de membrane mince respectivement référencées 52 et 54. Ces portions de membrane ont la même longueur que le barreau et ont une forme sensiblement rectangulaire en vue de dessus. La différence d'épaisseur entre le barreau 50 et les portions de membrane 52 et 54 définit deux paires de demi-flancs respectivement référencés 56, 56' et 58, 58', chaque demi-flanc étant disposé de part et d'autre de la membrane. Ces flancs sont couverts par des métallisations 56, 56'a et 58a, 58'a. A la hauteur des axes nodaux $X_1X'_1$ et $X_2X'_2$ du barreau, des prolongements 60, 62, 64 et 66 de fixation de l'élément oscillant sur un boîtier sont prévus. Des métallisations 60', 62', 64' et 66' sont également prévues selon les axes nodaux $X_1X'_1$ et $X_2X'_2$ , qui permettent de relier les portions d'électrodes à des sources électriques extérieures.

Comme cela est bien connu, en appliquant une même tension sur les demi-électrodes 56a et 58'a et sur les demi-électrodes 56'a et 58a, la barreau travaille en flexion.

L'élément vibrant des figures 6 peut être monté dans un capteur de pression comme le montre la figure 8. Un tel capteur fonctionne bien sûr en pression absolue puisque la même pression (pression à mesurer) existe sur les deux faces de l'élément vibrant. L'élément est monté sur quatre supports fixes (seuls les supports 80 et 82 sont visibles sur la figure 9) dont les extrémités supérieures sont solidaires des extrémités des prolongements 60 à 66 disposés selon les lignes nodales du barreau vibrant 50. Comme cela a déjà été expliqué les liaisons électriques sont réalisées par les métallisations 60' à 66'. Le circuit électrique de traitement des signaux est identique à celui qui a été décrit en liaison avec les figures 8.

REVENDICATIONS

1. Elément vibrant pour détecteur de pression caractérisé en ce qu'il comprend un cristal piézo-électrique dans lequel est taillé au moins un barreau allongé épais (6, 8, 10, 50) et des portions de membrane mince (12, 52, 54) disposées de chaque côté dudit barreau selon le sens de sa longueur, et des métallisations conductrices (18, 18', 56a, 56'a, 56b, 56'b) disposées sur ledit barreau formant des électrodes pour créer dans ledit barreau un champ électrique sensiblement perpendiculaire à la longueur dudit barreau.

2. Elément selon la renvendication 1, caractérisé en ce que ledit cristal est taillé pour avoir la forme générale d'un disque (4) et pour définir une pluralité de barreaux (6, 8, 10) dont les longueurs sont disposées selon des rayons du disque et une pluralité de portions de membrane mince (12) en forme de secteurs de cercle réunissant lesdits barreaux.

3. Elément selon la revendications 2, caractérisé en ce qu'il présente un plan de symétrie perpendiculaire à son axe.

4. Elément selon la revendication 3, caractérisé en ce que la différence d'épaisseur entre les barreaux (6, 8, 10) et les portions de membrane mince (12) définit pour chaque barreau des demi-flancs sensiblement perpendiculaires au plan de symétrie dudit élément et disposés de part et d'autre des portions de membrane (12), et en ce que chaque demi-flanc de chaque barreau est muni d'une électrode (18, 18') s'étendant sensiblement sur toute sa longueur.

5. Elément selon la revendication 4, caractérisé en ce que le matériau piézo-électrique est du quartz, en ce que le plan de symétrie de l'élément est sensiblement perpendiculaire à l'axe optique Z du quartz, et en ce que les barreaux (6, 8, 10), qui sont au nombre de trois, sont taillés pour que leurs longueurs soient sensiblement disposées selon les trois axes Y du quartz.

6. Elément selon l'une quelconque des revendications 4 et 5, caractérisé en ce que ledit cristal est taillé pour former en outre une zone centrale épaisse (16) et un rebord périphérique épais (14) entre lesquels les barreaux (6, 8, 10) sont encastrés.

7. Elément selon la renvendication 1, caractérisé en ce que ledit cristal piézo-électrique est taillé pour former un seul barreau allongé (50) et deux portions de membrane (52, 54) de forme sensiblement rectangulaire.

8. Elément selon la revendication 7, caractérisé en ce qu'il présente un plan de symétrie contenant l'axe longitudinal du barreau.

9. Elément selon la revendication 8, caractérisé en ce que la différence d'épaisseur entre le barreau (50) et les portions de membrane mince (52, 54) définit des demi-flancs sensiblement perpendiculaires au plan de symétrie et disposés de part et d'autre des portions de membrane, et en ce que chaque demi-flanc est muni d'une électrode (56a, 56'a, 56b, 56'b) s'étendant sensiblement sur toute la longueur dudit barreau (50).

10. Elément selon la revendication 9, caractérisé en ce que le matériau piézo-électrique est du quartz, en ce que le plan de symétrie de l'élément est sensiblement perpendiculaire à l'axe optique Z du quartz et en ce que le barreau (50) est taillé pour que sa longueur soit sensiblement disposée selon un axe Y du quartz.

11. Détecteur de pression caractérisé en ce qu'il comprend un boîtier (30) formant une cavité (32) et ouvert à une extrémité, un élément vibrant (2) selon l'une quelconque des revendications 1 à 6, fermant de façon étanche ladite ouverture, ladite cavité (32) étant mise sous une pression réduite, des moyens pour appliquer un signal électrique aux électrodes (18, 18') dudit élément vibrant et des moyens pour recueillir le signal délivré par ledit élément vibrant et convertir sa fréquence en une indication de la différence de pression à laquelle ledit élément vibrant est soumis.

1/5

0060217

Fig.1

Fig.2

Fig.3

Fig.4

Fig. 5

Fig. 6a

Fig. 6b

Fig.7

Fig.9

Fig.8a

4/5

0060217

Fig.8b

Fig.8c

Fig.8d

**0060217**

Numéro de la demande

**Office européen des brevets**

## RAPPORT DE RECHERCHE EUROPEENNE

EP 82 81 0078

### DOCUMENTS CONSIDERES COMME PERTINENTS

| Catégorie | Citation du document avec indication, en cas de besoin, des parties pertinentes | Revendication concernée |
|---|---|---|
| A | US - A - 4 065 970 (LESLIE B. WILNER)<br><br>* Resumé; revendications 1-4,13; figures 3,6,8,9,11 *<br><br>-- | 1-4,11 |
| A | US - A - 3 764 950 (PERRY S. WALLIA)<br><br>* Resumé; revendication 1; figures 4a,4b *<br><br>-- | 1-3 |
| A | US - A - 3 341 794 (CECIL K. STEDMAN)<br><br>* Resumé; colonne 11, ligne 70 à colonne 12, ligne 35; revendications 1,6; figures 1,1B, 5,8 *<br><br>---- | 1-3, 6,11 |

**CLASSEMENT DE LA DEMANDE (Int. Cl. 3)**

G 01 L  9/00
           9/08
H 01 L 41/08

**DOMAINES TECHNIQUES RECHERCHES (Int. Cl. 3)**

G 01 L
H 01 L

**CATEGORIE DES DOCUMENTS CITES**

X: particulièrement pertinent à lui seul
Y: particulièrement pertinent en combinaison avec un autre document de la même catégorie
A: arrière-plan technologique
O: divulgation non-écrite
P: document intercalaire
T: théorie ou principe à la base de l'invention
E: document de brevet antérieur, mais publié à la date de dépôt ou après cette date
D: cité dans la demande
L: cité pour d'autres raisons

&: membre de la même famille, document correspondant

X  Le présent rapport de recherche a été établi pour toutes les revendications

| Lieu de la recherche | Date d'achevement de la recherche | Examinateur |
|---|---|---|
| La Haye | 19-05-1982 | VISENTIN |

OEB Form 1503.1  06.78